# EUROPEAN PATENT APPLICATION

(11) **EP 4 307 505 A1**
(43) Date of publication of application: **17.01.2024**
(21) Application number: 23156312.3
(22) Date of filing: 13.02.2023
(51) Int. Cl.: H02H 1/00, H02H 3/50

(54) **A METHOD FOR PROTECTING A MAINS AGAINST A SUCCESSIVE ARC FAULT AND A DEVICE FOR PERFORMING THE CLAIMED METHOD**

(30) Priority: 04.07.2022 UA 202202297
(71) Applicant: Ovcharyk, Ivan, 08630 Hlevakha Kyiv region (UA); Pavelko, Taras, 33002 Rivne Rivne region (UA); Havrilov, Anton, 65025 Odesa Odesa region (UA); Khodakov, Kostiantyn, 45602 Pidhaytsi Volyn region (UA)
(72) Inventor: Ovcharyk, Ivan, 08630 Hlevakha Kyiv region (UA); Pavelko, Taras, 33002 Rivne Rivne region (UA); Havrilov, Anton, 65025 Odesa Odesa region (UA); Khodakov, Kostiantyn, 45602 Pidhaytsi Volyn region (UA)
(74) Representative: AOMB Polska Sp. z.o.o.

(57) **Abstract**

A group of inventions relates to a field of electricity, namely, to emergency protection systems intended to detect a successive arc fault occurring in an electrical circuit, to a method for protecting against the same, and to a device for performing said method.

The proposed technical solution enables to provide a reliable and algorithmically simple method for protecting a mains against a successive arc fault, and a structurally simple, easy to manufacture and to mount device for performing the same, which allow to achieve a technical effect that lies in providing a high sensitivity of detecting the successive arc fault, while minimizing a sensitivity to signals that occur in the mains during operation of certain devices such as rotational motors, switching mode power supply units and other, and, as a consequence, significantly reducing "faulty activations" due to isolation and analysis of a high frequency and a low frequency signals which are signs that the fault is present, and comparing these signals on a comparator to dynamic reference signals having a level that forms as a function of a phase of a mains sine curve.

## Description

### FIELD OF THE INVENTION

A group of inventions relates to a field of electricity, namely, to emergency protection systems for detecting a successive arc fault that occurs in an electrical circuit, to a method for protecting against the same, and to a device for performing the claimed method.

### PRIOR ART

An arc fault is a spontaneous occurrence of a successive or a parallel electric arc between conductors which causes their dangerous local overheat and an ignition of an insulation and adjacent structures, and it is one of main causes of house fires due to an electrical malfunction. An example of the parallel arc fault occurring between two conductors, i.e., between a phase conductor and a neutral conductor or between a phase conductor and an earth conductor, is a damage of a power cable or wire insulation which allows a transmission of an electric current between said conductors through the damaged insulation. The parallel arc fault usually turns into a short circuit that causes actuation of a protection against an excessive current by means of traditional fuses, automatic breakers (AB), differential current devices or a combination thereof. The successive arc fault occurs between ends of the electric circuit break of a single conductor. Typical reasons for its occurrence are a long overheat of wires having an insufficient section, aging of insulating materials, local damages of wires, e.g., caused by rodents, furniture or due to incomplete mounting, loosened contacts of sockets, switches, and cartridges for electric lamps. The insulation also may be damaged due to a high humidity in a room or to a long-term action of an ultraviolet radiation (Erashova Yu. N., Ivshin I. V., Ivshin I. I., Tyurin A. N. Device for testing arc fault and spark gap protection devices// News of higher education institutions. ENERGY PROBLEMS. 2021. T. 23. No. 3. S. 168-180. doi:10.30724/1998-9903-2021-23-3-168-180.2AO «TATELEKTROMONTAZH», Kazan, Russia// https://www.energyret.ru/jour/article/vie w/1852/764). The successive arc fault is more dangerous as compared to the parallel arc fault, since it is not detectable within a voltage circuit both with automatic breakers and with differential current devices, as well as with their combination, since the current that flows across the circuit in case of the successive arc fault is less than the current that flows across a serviceable circuit.

In recent decades, owing to development of electronics and to a possibility of a wide use of relatively cheap microcontrollers, electronic arc fault protection devices (AFPDs) began to be used in order to reveal the arc fault and to reduce its negative effects by breaking the circuit, and these devices, by means of the microcontroller, track and analyze high-frequency components of the current by means of a digital processing of signals. The AFPDs are mainly used in household low-voltage mains, while their main purpose is to avoid a fire caused by the arc fault of a faulty wiring.

A prior art teaches a wide range of devices and methods for protecting against the successive arc fault, and the applicant has selected several technical solutions among them, which are the closest to the proposed group of inventions in terms of a set of essential features.

So, a patent US10060964 B2 dated August 28, 2018 teaches a system and a method for detecting an arc fault, which comprise a current measuring component that determines whether a frequency of current corresponds to a frequency of interest, at least one super regenerative high-frequency receiver tuned to the frequency of interest and configured to receive the current from the current measure component at the frequency of interest, to provide the current to a tank circuit of the at least one super regenerative high frequency receiver, to determine a time period for oscillations within the at least one super regenerative high frequency receiver corresponding to a consecutive occurrence of the current reaching a quench voltage for the tank circuit, and at least one microcontroller that is associated with the at least one super regenerative high frequency receiver and intended to determine an amplitude of the current based on the time period, and to determine whether an arc fault event is occurred based, at least in part, on the amplitude of the current followed by formation and sending a tripping signal to a tripping mechanism to quench the arc fault event. Therewith, the high-voltage receiver comprises serviceable inductance coil and condenser which form a resonant circuit, as well as a generator, a detector, and an amplitude detector. A drawback of the proposed technical solution lies in that the high-frequency receiver that is used in the electronic circuit, according to the claimed invention, is characterized by manufacturing complexity and mounting in automatic breakers and/or electricity distribution centers. Furthermore, the solution does not imply analyzing the signals regarding occurrence of low-frequency currents in the mains and using high-pass mains filters which intend to attenuate high-frequency interferences, thereby significantly reducing a system sensitivity upon detection of the arc fault within the mains, at the same time increasing cases of faulty activations.

An invention patent US10078105 B2 dated September 18, 2018 teaches an electrical system with arc fault detection, the system comprising a first electrical component; a second electrical component; a conductor electrically coupling the first electrical component with the second electrical component; a sensor intended to detect an AC power flow in the conductor and to form an AC signal proportional to the AC power flow; a band-pass filter in electrical communication with the sensor and intended to receive and to filter the AC signal, wherein the filter is intended to pass AC signals at frequencies associated with arcing and to hold AC signals at other frequencies, and to generate an AC voltage proportional to the AC signals that are passed by the band-pass filter; a controller in electrical communication with the band-pass filter, the controller being operative to receive and sample the AC voltage from the band-pass filter and being configured to sum sequential AC voltage values received from the band-pass filter over a defined time period. According to the proposed technical solution, a determination whether an arc fault has occurred is based on the summed AC voltage values, wherein the controller is configured to generate a weighted counter, wherein the weighted counter is constructed to increment a count when the summed AC voltage values exceed a threshold value, and to decrement the count when the summed AC voltage values do not exceed the threshold value, and the controller is further configured to set an arc fault flag in response to the count exceeding a threshold count. A drawback of the proposed technical solution lies in that as the band-pass filters, three Sallen-Key sixth-order band-pass filters are preferably used, the filters have three operational amplifiers, which are characterized by a structural complexity, a relatively high parametric sensitivity to parasitic parameters of the operational amplifier, as well as by the fact that temperature coefficients of passive RC elements of the filter do not allow to compensate for changes of not only amplitude-frequency, but also phase-frequency characteristics within a bandwidth, which are caused by the operation of the operational amplifier.

A patent US8373570 B2 dated February 12, 2013 teaches a method and a device which may be used to detect both parallel and successive arc faults. According to the proposed technical solution, a load current from an electrical supply circuit is monitored so that both high-frequency and low-frequency signals are measured over defined time periods. Therewith, according to the claimed invention, signals at a level of 60 Hz are meant as the low-frequency signals, while signals at a level of 10 - 100 kHz are meant as the high-frequency signals. The high-frequency signals are measured by an integral method, e.g., by summing a plurality of samples taken, and to detect that an arc event is occurred, a certain amount of a high-frequency energy during a half-cycle is required, wherein a defined number of these arc events per half-cycle must occur within a specific time period to indicate a presence of the arc. A root-mean-square (RMS) value of the low frequency energy component is used to determine a severity of the arc. The higher the amperage of the load current, the faster an AFCI will respond by disconnecting the load from an AC source, and the fewer will be the number of the arc events as calculated based on the high-frequency signals necessary for actuation of the AFCI. The low-frequency signals and the high-frequency signals are calculated by means of a mixed signals device preferably being a microcontroller that comprises a digital signal processor, logical circuits, and control circuits, an analog-digital converter, and a pulse width modulation (PWM) generator. A drawback of the proposed technical solution lies in that it implies processing of the signal in a relatively narrow frequency range within a range of up to 100 kHz, and it is not adapted to detect the arc fault at higher frequencies, thereby leading to a significant reduction of the sensitivity of the claimed method and device, since a characteristic feature of the arc fault current is a rather wide spectrum of frequencies distribution reaching values of up to 1 GHz.

A device and a method for protecting against a successive arc fault according to a patent US11105864 B2 dated August 31, 2021 are taken as the closest analogue of the invention, the device and the method imply a presence of a first conductive path and a second conductive path; a low frequency sensor, wherein the first conductive path passes through the low frequency sensor; a high frequency sensor, wherein the first and second conductive paths pass through the high frequency sensor; a microprocessor; an interrupt circuit configured to interrupt one or more of the first and second conductive paths responsive to an interrupt signal received from the microprocessor. According to the invention, the microprocessor is configured to process an output data of the low frequency sensor and an output data of the high frequency sensor to determine that an arc fault condition exists, wherein the processing is based on a plurality of current measurements by the low frequency sensor or a plurality of current measurements by the high frequency sensor, and the processing includes calculating at least one of a current jump, an average current, and a maximum average current, and then the microprocessor transmits the interrupt signal to the interrupt circuit based on the determination that the arc fault condition exists. Therewith, the current jump is a difference in current values between two successive current measurements of the plurality of current measurements, the average current is an average of the plurality of current measurements, and the maximum average current is a maximum of a plurality of average currents of the plurality of current measurements. According to the proposed technical solution, the high frequency sensor is a transformer having a coil wound around an air core or a high permeability magnetic core, while the low frequency sensor is a typical current sensor or a current transformer, wherein the sensors are configured to detect arc faults within a defined frequency range. In various exemplary embodiments, ranges of the high frequencies correspond to values higher than the conductive path frequency, i.e., higher than 1 MHz or they are higher than 2 MHz or higher than 4 MHz, while ranges of the low frequencies correspond to the conductive path frequency or are from 0 to 2 MHz or from 0 to 4 MHz respectively. A drawback of the proposed technical solution lies in a complex algorithm of implementation thereof, as well as the fact that in order to reduce a negative impact of extraneous noises that occur, e.g., under the voltage action, in addition to use of the high-pass filter, various combinations of mutual arrangement of the sensors are used as well, for example, the low frequency sensor may be arranged within the high frequency sensor or vice versa which is not sufficiently effective, increases a risk of faulty activations and, thus, negatively affects the operation efficiency of the claimed device, as well as significantly complicates its structure and requires a housing having greater dimensions.

### SUMMARY OF THE INVENTION

The group of inventions is based on a task to provide a reliable and algorithmically simple method for protecting a mains against a successive arc fault, and a structurally simple, easy-to-manufacture and easy-to-mount device for performing the same, which allow to achieve a technical effect that lies in providing a high sensitivity of detecting the successive arc fault, while minimizing a sensitivity to signals that occur in the mains during operation of certain devices such as rotational motors, switching mode power supply units and other, and, as a consequence, significantly reducing "faulty activations" due to isolation and analysis of a high frequency signal and a low frequency signal which are signs of presence of the fault, and comparing these signals on a comparator to dynamic reference signals having a level that forms as a function of a phase of a mains sine curve.

The posed task is resolved by that the method for protecting the mains against the successive arc fault comprises:
isolating a high frequency signal from an output of a current transformer 1 having a bandwidth of 5.0 MHz at most through a passive filter 2 having a pass frequency of at least 1.8 MHz and supplying it to a first input of a comparator 3 of a high frequency error channel 4. In a process of conducting multiple researches, it has been established that the limitation of the lower threshold of the frequency to at least 1.8 MHz significantly reduces the level of the signals which occur in the mains during the operation of certain devices and, as a consequence, a probability that these signals will be perceived as signs of the fault;
simultaneously, supplying a dynamic reference signal through an integrator 5 that converts a PWM signal into an analog signal to a second input of the comparator 3 of the high frequency error channel 4, the dynamic reference signal is formed by a PWM signal generator module 6 for the high frequency error channel 4 as a flow of rectangular pulses having a frequency of 100.0 kHz, wherein a duty cycle of the PWM signal is formed as a function of a phase of a fundamental sine curve of the mains, namely by: setting the duty cycle of the PWM signal within 33 - 39% starting from a point of zero-crossing of the mains sine curve till an end of a first 1/8 of its period, within 0 - 6% from a start till an end of a second 1/8 of its period, within 60 - 67% from a start of a third 1/8 of its period and till an end of a fifth 1/8 of its period, within 94 - 100% from a start and till an end of a sixth 1/8 of its period, within 33 - 39% from a start of a seventh 1/8 of its period and till an end of the period. In a process of conducting multiple researches, it has been established that the signals which are similar to the signals from the fault, but generated by certain devices within the mains, correlate with the phase of the mains sine curve in terms of their level. The signals which occur during the fault do not have such dependence on the phase of the mains sine curve. The inventors have proven that owing to the setting of the duty level of the reference PWM signal during each 1/8 of the period of the mains sine curve within the mentioned particular limits, the probability that the signals from the devices, which may generate high frequency signals according to their operation principle, will be perceived as similar to the signals, which occur when the fault takes place, will be significantly reduced;
when the signal level in the high frequency error channel 4 exceeds the reference signal by more than 1 mV, forming a "yes" signal, and supplying and storing this signal in an error accumulator module 9 of the high frequency error channel 4 of a controller 10;
isolating a low frequency signal from the output of the current transformer 1 through a passive filter 11 having a frequency of 5 kHz at most, and supplying it through a variable component amplifier 12 having an amplification factor of 20 ± 10% to a first input of a comparator 13 of a low frequency error channel 14. Since the low frequency signals are often weaker than similar signals of certain devices, such amplification significantly increases a probability that the particular signal that results from the fault will be detected. Comparative researches have demonstrated that this particular amplification factor is optimal in order to screen out undesired low frequency signals which do not originate from the fault.

Simultaneously, the method comprises supplying a dynamic reference signal through an integrator 15 that converts a PWM signal into an analog signal to a second input of the comparator 13 of the low frequency error channel 14, the dynamic reference signal is formed by a PWM signal generator module 16 for the low frequency error channel 14 as a flow of rectangular pulses having a frequency of 100.0 kHz, wherein a duty cycle of the PWM signal is formed as a function of a phase of a fundamental sine curve of the mains starting from its zero-crossing point, namely by: setting the duty cycle within 54 - 60% starting from a point of zero-crossing of the mains sine curve till an end of a first 1/8 of its period, within 70 - 76% from a start till an end of a second 1/8 of its period, within 40 - 46% from a start of a third 1/8 of its period and till an end of a fifth 1/8 of its period, within 24 - 30% from a start and till an end of a sixth 1/8 of its period, within 54 - 60% from a start of a seventh 1/8 of its period and till an end of the period.

It has been established that the low frequency signals which are similar to the signals resulting from the fault, but which are generated by certain consumers, depend on the phase of the mains sine curve that differs from the correlation of the signal from the fault itself. A large number of researches has been conducted and it has been statistically established that the formation of the dynamic reference signal having the level that depends on the phase of the mains sine curve reduces the probability that the undesired signals will be perceived as the signals resulted from the fault. Imitation of a situation, where there is absolutely no fault in the mains, but a consumer is connected such as a rotational motor or a switching mode power supply unit that generates similar signals, has demonstrated that the above-mentioned particular duty levels of the reference PWM signal during the period of the mains sine curve significantly reduce the probability that the similar signals will be perceived as the signals resulted from the fault. The reference PWM signals through the integrator form variable analog signals having the level that depends on the duty cycle of the PWM signals which are supplied to the inputs of the comparators simultaneously with the signals isolated in the channels.

When the signal level in the low frequency error channel 14 exceeds the reference signal by more than 1 mV, forming a "yes" signal, and supplying and storing this signal in an error accumulator module 17 of the low frequency error channel 14 of a controller 10;
after accumulation of at least four "yes" signals from the high frequency error channel 4 and accumulation of at least three "yes" signals from the low frequency error channel 14 during at least three periods of the mains sine curve, a module 18 for verifying an achievement of a condition for detecting the arc fault of the controller 10 forms and supplies a mains breakage command to a relay 19.

Therewith, according to an embodiment of the invention of claim 2, the low frequency signal from the output of the variable component amplifier 12 is supplied to the comparator 13 of the low frequency error channel 14 through an additional filter 20 that has a bandwidth of 3.0 kHz at most and operates to narrow the bandwidth for the amplified signal down to the required one in the low frequency error channel in order to increase the probability of screening out the low frequency signals which are generated by certain consumers, while at the same time preserving the sensitivity to the particular signals resulting from the fault. In the process of conducting multiple researches, it has been established that the narrowing the bandwidth of the low frequency signal directly after the amplification thereof further reduces the probability that the undesired signals will be perceived as the signals of the fault and, together with the formation of the dynamic reference signal, makes the probability of erroneous detection of the fault very low.

A second invention of the group of inventions is a device for protecting a mains against a successive arc fault, the device comprises the high frequency current transformer 1 that is connected to the input of the comparator 3 through the passive filter 2 having the bandwidth of at least 1.8 MHz, thereby forming the high frequency error channel 4, and to the input of the comparator 13 through the passive filter 11 having the bandwidth of 5 kHz at most and through the variable component amplifier 12, thereby forming the low frequency error channel 14. The device further comprises the controller 10 that is connected to the mains breakage relay 19, to a sensor 8 of zero-crossing of the mains sine curve, to the output of the comparator 3 and, through the integrator 5, to the input of the comparator 3, to the output of the comparator 13 and, through the integrator 15, to the input of the comparator 13, and it comprises a timer 7, the high frequency error accumulator program module 9, the low frequency error accumulator program module 17, the reference PWM signal generator program module 6 for the comparator 3, the reference PWM signal generator program module 16 for the comparator 13, the program module 18 for verifying an achievement of a condition for detecting the arc fault that is connected to the mains breakage relay 19.

Therewith, according to an embodiment of the invention of claim 4, the additional filter 20 is arranged in the low frequency error channel 14 between the output of the variable component amplifier 12 and the input of the comparator 13, the additional filter has the bandwidth of 3 kHz at most and operates to narrow the bandwidth for the amplified signal down to the required one in the low frequency error channel in order to increase the probability of screening out the low frequency signals which are generated by certain consumers, while at the same time preserving the sensitivity to the particular signals resulting from the fault.

### BRIEF DESCRIPTION OF THE DRAWINGS

A possibility of implementation of the group of inventions is illustrated by the drawings, which depict the following.
Fig. 1 shows a flow chart of a preferable embodiment of a method for protecting a mains against a successive arc fault according to claim 1.
Fig. 2 shows a flow chart of an embodiment of a method for protecting a mains against a successive arc fault according to claim 2.
Fig. 3 shows a graphical illustration of a mains voltage U change as a function of time t in a form of a fundamental sine curve of the mains starting from its zero-crossing point during one period.
Fig. 4 shows a general view of a housing of a device that comprises an integrated module for protecting a mains against a successive arc fault.
Fig. 5 shows a graphical illustration of a printed circuit board having a current transformer and a microcontroller mounted thereon.

The illustrative drawings that explain the claimed group of inventions as well as the mentioned particular exemplary embodiments are in no way intended to limit the scope of rights appended hereto but to explain the essence of the group of inventions.

### IMPLEMENTATION OF THE INVENTION

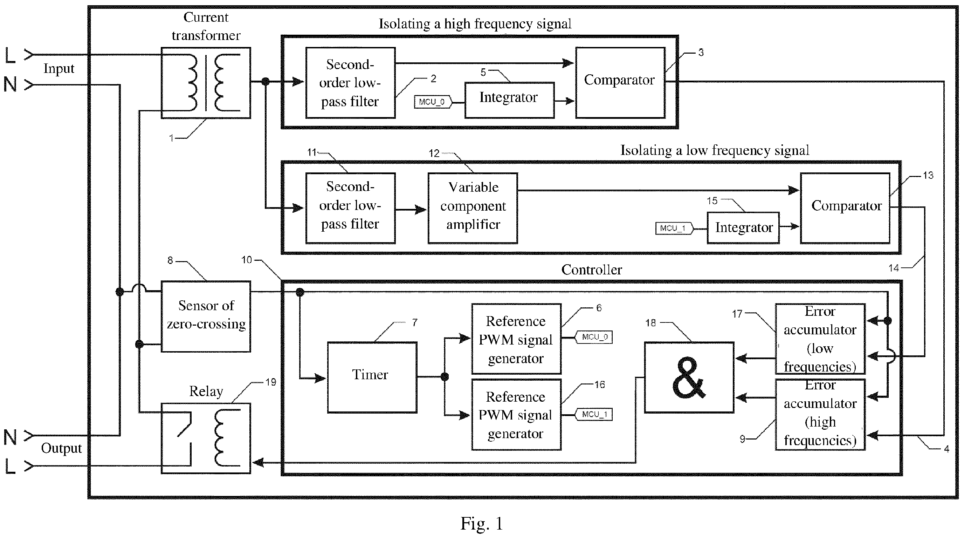

Fig. 1 shows a flow chart of a preferable embodiment of a method for protecting a mains against a successive arc fault according to claim 1, according to which, the method comprises isolating a high frequency signal from an output of a current transformer 1 having a bandwidth of 5.0 MHz at most through a passive filter 2 having a pass frequency of at least 1.8 MHz and supplying it to a first input of a comparator 3 of a high frequency error channel 4. Simultaneously, the method comprises supplying a dynamic reference signal (MCU_0) through an integrator 5 to a second input of the comparator 3 of the high frequency error channel 4, the dynamic reference signal is formed by a PWM signal generator module 6 for the high frequency error channel 4 as a flow of rectangular pulses having a frequency of 100 kHz, wherein a duty cycle of the PWM signal is formed by means of a timer 7 and a sensor 8 of zero-crossing of the mains sine curve as a function of a phase of the fundamental sine curve of the mains starting from a point of the zero-crossing of the mains sine curve, namely by: setting the duty cycle of the PWM signal within 33 - 39% starting from a point of zero-crossing of the mains sine curve till an end of a first 1/8 of its period, within 0 - 6% from a start till an end of a second 1/8 of its period, within 60 - 67% from a start of a third 1/8 of its period and till an end of a fifth 1/8 of its period, within 94 - 100% from a start and till an end of a sixth 1/8 of its period, within 33 - 39% from a start of a seventh 1/8 of its period and till an end of the period. When the signal level in the high frequency error channel 4 exceeds the reference signal (MCU_0) by more than 1 mV, a "yes" signal is formed, and this signal is supplied and stored in an error accumulator module 9 of the high frequency error channel 4 of a controller 10.

According to the proposed flow chart, the method also comprises isolating a low frequency signal from the output of the current transformer 1 through a passive filter 11 having a frequency of 5 kHz at most, and supplying it through a variable component amplifier 12 having an amplification factor of 20 ± 10% to a first input of a comparator 13 of a low frequency error channel 14. Therewith, in the proposed embodiment of the invention, the passive filter 11 is a second-order low-pass filter, although any other filter may be used without falling beyond the principles of the present invention which is obvious for a person skilled in the art. Simultaneously, the method comprises supplying a dynamic reference signal MCU_1 through an integrator 15 to a second input of the comparator 13 of the low frequency error channel 14, the dynamic reference signal is formed by a PWM signal generator module 16 for the low frequency error channel 14 as a flow of rectangular pulses having a frequency of 100 kHz, wherein a duty cycle of the PWM signal is formed as a function of a phase of a fundamental sine curve of the mains starting from its zero-crossing point, namely by: setting the duty cycle within 54 - 60% starting from a point of zero-crossing of the mains sine curve till an end of a first 1/8 of its period, within 70 - 76% from a start till an end of a second 1/8 of its period, within 40 - 46% from a start of a third 1/8 of its period and till an end of a fifth 1/8 of its period, within 24 - 30% from a start and till an end of a sixth 1/8 of its period, within 54 - 60% from a start of a seventh 1/8 of its period and till an end of the period. When the signal level in the low frequency error channel 14 exceeds the reference signal MCU_1 by more than 1 mV, a "yes" signal is formed, and this signal is supplied and stored in an error accumulator module 17 of the low frequency error channel 14 of the controller 10.

After accumulation of at least four "yes" signals from the high frequency error channel 4 and accumulation of at least three "yes" signals from the low frequency error channel 14 during at least three periods of the mains sine curve, a module 18 for verifying an achievement of a condition for detecting the arc fault of the controller 10 forms and supplies a mains breakage command to a relay 19.

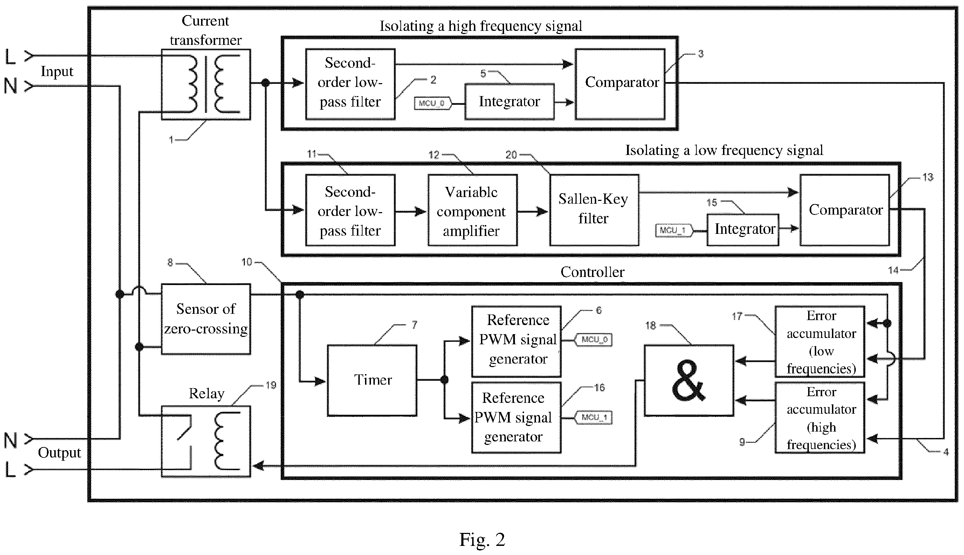

Fig. 2 shows a flow chart of an embodiment of a method for protecting a mains against a successive arc fault according to claim 2, according to which, the method comprises isolating a high frequency signal from an output of a current transformer 1 having a bandwidth of 5.0 MHz at most through a passive filter 2 having a pass frequency of at least 1.8 MHz and supplying it to a first input of a comparator 3 of a high frequency error channel 4. Simultaneously, the method comprises supplying a dynamic reference signal (MCU_0) through an integrator 5 to a second input of the comparator 3 of the high frequency error channel 4, the dynamic reference signal is formed by a PWM signal generator module 6 for the high frequency error channel 4 as a flow of rectangular pulses having a frequency of 100.0 kHz, wherein a duty cycle of the PWM signal is formed by means of a timer 7 and a sensor 8 of zero-crossing of the mains sine curve as a function of a phase of the fundamental sine curve of the mains starting from a point of the zero-crossing of the mains sine curve, namely by: setting the duty cycle of the PWM signal within 33 - 39% starting from a point of zero-crossing of the mains sine curve till an end of a first 1/8 of its period, within 0 - 6% from a start till an end of a second 1/8 of its period, within 60 - 67% from a start of a third 1/8 of its period and till an end of a fifth 1/8 of its period, within 94 - 100% from a start and till an end of a sixth 1/8 of its period, within 33 - 39% from a start of a seventh 1/8 of its period and till an end of the period. When the signal level in the high frequency error channel 4 exceeds the reference signal (MCU_0) by more than 1 mV, a "yes" signal is formed, and this signal is supplied and stored in an error accumulator module 9 of the high frequency error channel 4 of a controller 10.

According to the proposed flow chart, the method comprises isolating a low frequency signal from the output of the current transformer 1 through a passive filter 11 having a frequency of 5 kHz at most, and supplying it through a variable component amplifier 12 having an amplification factor of 20 ± 10% to a first input of a comparator 13 of a low frequency error channel 14. Therewith, in the proposed embodiment of the invention, the passive filter 11 is a second-order low-pass filter, although any other filter may be used without falling beyond the principles of the present invention which is obvious for a person skilled in the art. An additional low-pass Sallen-Key filter 20 is arranged in the low frequency error channel 14 between the output of the variable component amplifier 12 and the input of the comparator 13, the additional filter has the bandwidth of 3 kHz at most and operates to narrow the bandwidth for the amplified signal down to the required one in the low frequency error channel in order to increase the probability of screening out the low frequency signals which are generated by certain consumers, while at the same time preserving the sensitivity to the particular signals resulting from the fault. Simultaneously, the method comprises supplying a dynamic reference signal MCU_1 through an integrator 15 to a second input of the comparator 13 of the low frequency error channel 14, the dynamic reference signal is formed by a PWM signal generator module 16 for the low frequency error channel 14 as a flow of rectangular pulses having a frequency of 100.0 kHz, wherein a duty cycle of the PWM signal is formed as a function of a phase of a fundamental sine curve of the mains starting from its zero-crossing point, namely by: setting the duty cycle within 54 - 60% starting from a point of zero-crossing of the mains sine curve till an end of a first 1/8 of its period, within 70 - 76% from a start till an end of a second 1/8 of its period, within 40 - 46% from a start of a third 1/8 of its period and till an end of a fifth 1/8 of its period, within 24 - 30% from a start and till an end of a sixth 1/8 of its period, within 54 - 60% from a start of a seventh 1/8 of its period and till an end of the period. When the signal level in the low frequency error channel 14 exceeds the reference signal MCU_1 by more than 1 mV, a "yes" signal is formed, and this signal is supplied and stored in an error accumulator module 17 of the low frequency error channel 14 of the controller 10.

After accumulation of at least four "yes" signals from the high frequency error channel 4 and accumulation of at least three "yes" signals from the low frequency error channel 14 during at least three periods of the mains sine curve, a module 18 for verifying an achievement of a condition for detecting the arc fault of the controller 10 forms and supplies a mains breakage command to a relay 19.

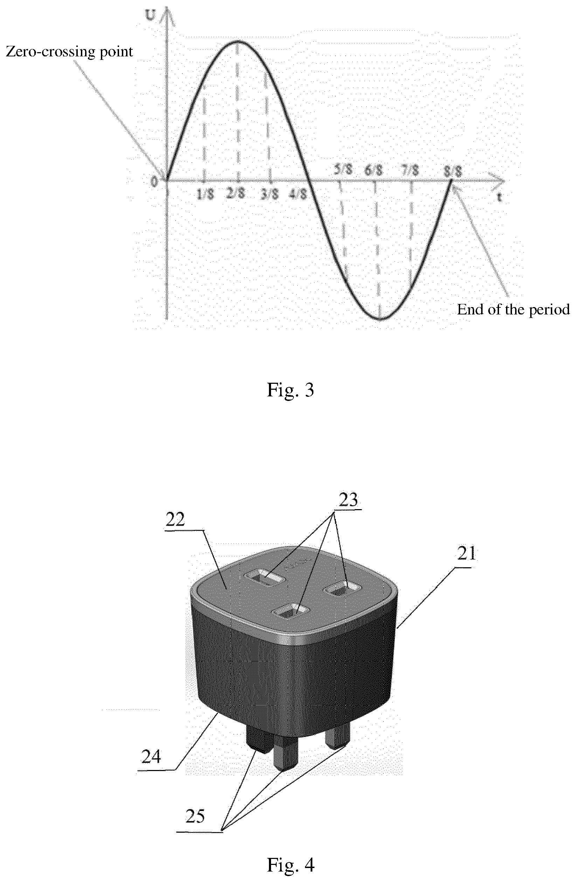

Fig. 3 shows a graphical illustration of a mains voltage U change as a function of time t in a form of a fundamental sine curve of the mains starting from its zero-crossing point during one period. Therewith, the period is conditionally divided into eight parts: 1/8 - a first 1/8 of the period, 2/8 - a second 1/8 of the period, 3/8 - a third 1/8 of the period, 4/8 - a fourth 1/8 of the period, 5/8 - a fifth 1/8 of the period, 6/8 - a sixth 1/8 of the period, 7/8 - a seventh 1/8 of the period, 8/8 - an end of the period, and the corresponding duty cycles of the PWM signal according to claim 1 of the present group of inventions are set within them.

Fig. 4 shows a general view of a housing 21 of the device that comprises an integrated module for protecting a mains against a successive arc fault that operates according to one of the flow charts depicted in Fig. 1 or in Fig. 2. A front surface 22 of the housing 21 is provided with openings 23 which are configured so as to be equipped with caps. End contacts and terminals for supplying power to plugs of household devices to be inserted into the openings 23 are arranged inside the housing 21. A rear surface 24 of the housing 21 comprises contacts 25 to be inserted into openings of a socket. The device depicted in Fig. 4 is an intelligent socket or a smart socket being a separate module to be inserted into the socket, while, in turn, usual household devices are inserted therein. This illustrative material is used merely as an illustration of one of exemplary embodiments of the group of inventions and in no way limits the scope of rights presented in the claims. It should be understood that the module for protecting the mains against the successive arc fault may be mounted, e.g., in an installation box being a junction box for mounting socket mechanisms within a wall so as the socket remains unchanged from outside, without falling beyond the principles of the present invention.

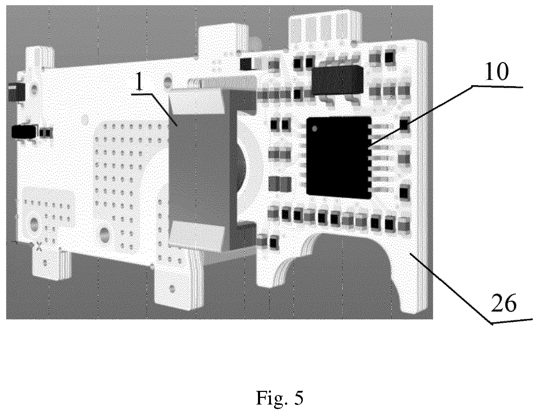

Fig. 5 shows a graphical illustration of a printed circuit board 26 having the current transformer 1 and a microcontroller 10 mounted thereon. Therewith, the printed circuit board may be arranged using known elements. For example, in one of exemplary embodiments of the group of inventions, the inventors have used a CC1310 model microcontroller provided by the Texas Instruments company and the current transformer of their own structure that is built in a form of a planar transformer using a B65525J0000R049 model ferrite provided by the TDK company. It should be understood that any other microcontrollers and transformers provided by any other manufacturers, as well as embodiments of configurations of the printed circuit board arrangement, may be embodied without falling beyond the principles of the present group of inventions.

It should be understood that the above-described embodiments of the group of inventions must be used merely as an illustration and shall not limit the scope thereof. Obvious modifications of embodiments of the group of inventions may be easily made by persons skilled in this field of art without going beyond the essence thereof.

## Claims

1. A method for protecting a mains against a successive arc fault, the method comprising:
isolating a high frequency signal from an output of a current transformer 1 having a bandwidth of 5.0 MHz at most through a passive filter 2 having a pass frequency of at least 1.8 MHz and supplying it to a first input of a comparator 3 of a high frequency error channel 4;
simultaneously, supplying a dynamic reference signal through an integrator 5 to a second input of the comparator 3 of the high frequency error channel 4, the dynamic reference signal is formed by a pulse-width modulation signal (PWM signal) generator module 6 for the high frequency error channel 4 as a flow of rectangular pulses having a frequency of 100.0 kHz, wherein a duty cycle of the PWM signal is formed as a function of a phase of a fundamental sine curve of the mains, namely by: setting the duty cycle of the PWM signal within 33 - 39% starting from a point of zero-crossing of the mains sine curve till an end of a first 1/8 of its period, within 0 - 6% from a start till an end of a second 1/8 of its period, within 60 - 67% from a start of a third 1/8 of its period and till an end of a fifth 1/8 of its period, within 94 - 100% from a start and till an end of a sixth 1/8 of its period, within 33 - 39% from a start of a seventh 1/8 of its period and till an end of the period;
when the signal level in the high frequency error channel 4 exceeds the reference signal by more than 1 mV, forming a "yes" signal, and supplying and storing this signal in an error accumulator module 9 of the high frequency error channel 4 of a controller 10;
isolating a low frequency signal from the output of the current transformer 1 through a passive filter 11 having a frequency of 5 kHz at most, and supplying it through a variable component amplifier 12 having an amplification factor of 20 ± 10% to a first input of a comparator 13 of a low frequency error channel 14;
simultaneously, supplying a dynamic reference signal through an integrator 15 to a second input of the comparator 13 of the low frequency error channel 14, the dynamic reference signal is formed by a PWM signal generator module 16 for the low frequency error channel 14 as a flow of rectangular pulses having a frequency of 100.0 kHz, wherein a duty cycle of the PWM signal is formed as a function of a phase of a fundamental sine curve of the mains starting from its zero-crossing point, namely by: setting the duty cycle within 54 - 60% starting from a point of zero-crossing of the mains sine curve till an end of a first 1/8 of its period, within 70 - 76% from a start till an end of a second 1/8 of its period, within 40 - 46% from a start of a third 1/8 of its period and till an end of a fifth 1/8 of its period, within 24 - 30% from a start and till an end of a sixth 1/8 of its period, within 54 - 60% from a start of a seventh 1/8 of its period and till an end of the period;
when the signal level in the low frequency error channel 14 exceeds the reference signal by more than 1 mV, forming a "yes" signal, and supplying and storing this signal in an error accumulator module 17 of the low frequency error channel 14 of a controller 10;
after accumulation of at least four "yes" signals from the high frequency error channel 4 and accumulation of at least three "yes" signals from the low frequency error channel 14 during at least three periods of the mains sine curve, a module 18 for verifying an achievement of a condition for detecting the arc fault of the controller 10 forms and supplies a mains breakage command to a relay 19.

2. The method for protecting the mains against the successive arc fault according to claim 1, **wherein** the low frequency signal from the output of the variable component amplifier 12 is supplied to the comparator 13 of the low frequency error channel 14 through an additional filter 20 having a bandwidth of 3.0 kHz at most.

3. A device for protecting a mains against a successive arc fault, the device comprises a high frequency current transformer 1 that is connected to an input of a comparator 3 through a passive filter 2 having a bandwidth of at least 1.8 MHz, thereby forming a high frequency error channel 4, and to an input of a comparator 13 through a passive filter 11 having a bandwidth of 5 kHz at most and through a variable component amplifier 12, thereby forming a low frequency error channel 14; a controller 10 that is connected to a mains breakage relay 19, to a sensor 8 of zero-crossing of the mains sine curve, to an output of the comparator 3 and, through an integrator 5, to the input of the comparator 3, to an output of the comparator 13 and, through an integrator 15, to the input of the comparator 13, and it comprises a timer 7, a high frequency error accumulator program module 9, a low frequency error accumulator program module 17, a reference PWM signal generator program module 6 for the comparator 3, a reference PWM signal generator program module 16 for the comparator 13, a program module 18 for verifying an achievement of a condition for detecting the arc fault that is connected to the mains breakage relay 19.

4. The device for protecting the mains against the successive arc fault according to claim 3, **wherein** an additional filter 20 is arranged in the low frequency error channel 14 between the output of the variable component amplifier 12 and the input of the comparator 13, the additional filter having a bandwidth of 3 kHz at most.
